(19) Europäisches Patentamt
European Patent Office
Office européen des brevets

(11) **EP 3 577 250 B1**

(12) **FASCICULE DE BREVET EUROPEEN**

(45) Date de publication et mention de la délivrance du brevet:
**09.08.2023 Bulletin 2023/32**

(21) Numéro de dépôt: **18705447.3**

(22) Date de dépôt: **02.02.2018**

(51) Classification Internationale des Brevets (IPC):
**C23C 14/08** (2006.01)   **C23C 14/48** (2006.01)
**C30B 29/20** (2006.01)   **C30B 33/00** (2006.01)
**C23C 14/58** (2006.01)

(52) Classification Coopérative des Brevets (CPC):
**C23C 14/48; C23C 14/081; C23C 14/5806;
C30B 29/20; C30B 33/00**

(86) Numéro de dépôt international:
**PCT/FR2018/050253**

(87) Numéro de publication internationale:
**WO 2018/142083 (09.08.2018 Gazette 2018/32)**

(54) **PROCÉDÉ DE TRAITEMENT ANTI-RÉFLECTIF ET RÉSISTANT À LA RAYURE DANS UN SAPHIR SYNTHÉTIQUE**

VERFAHREN ZUR ANTIREFLEKTIERENDEN UND KRATZFESTEN BEHANDLUNG VON SYNTHETISCHEM SAPHIR

METHOD FOR ANTI-REFLECTIVE AND SCRATCH-RESISTANT TREATMENT OF SYNTHETIC SAPPHIRE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.02.2017 FR 1770113**

(43) Date de publication de la demande:
**11.12.2019 Bulletin 2019/50**

(73) Titulaire: **Ionics France
14200 Herouville-Saint-Clair (FR)**

(72) Inventeurs:
• **BUSARDO, Denis
14510 Gonneville Sur Mer (FR)**
• **GUERNALEC, Frédéric
35340 Liffre (FR)**

(74) Mandataire: **Plasseraud IP
66, rue de la Chaussée d'Antin
75440 Paris Cedex 09 (FR)**

(56) Documents cités:
**WO-A1-2014/126551    US-A1- 2011 200 760
US-A1- 2014 070 119**

• **WILLIAM T SPRATT ET AL: "Effects of hydrogen ion implantation and thermal annealing on structural and optical properties of single-crystal sapphire", ION BEAMS - NEW APPICATIONS FROM MESOSCALE TO NANOSCALE : SYMPOSIUM HELD APRIL 25 - 29, 2011, SAN FRANCISCO, CALIFORNIA, U.S.A; [MATERIALS RESEARCH SOCIETY SYMPOSIUM PROCEEDINGS : MRSSP, ISSN 0272-9172 ; 1354], CAMBRIDGE UNIV. PRESS, NEW YORK, NY, vol. 1354, 25 avril 2011 (2011-04-25), pages 97-102, XP002729037, DOI: 10.1557/OPL.2011.1279 ISBN: 978-1-60511-331-9**
• **H. NARAMOTO ET AL: "Ion implantation and thermal annealing of [alpha]-Al2O3 single crystals", JOURNAL OF APPLIED PHYSICS, vol. 54, no. 2, 1 janvier 1983 (1983-01-01), page 683, XP055067228, ISSN: 0021-8979, DOI: 10.1063/1.332076**

**EP 3 577 250 B1**

**Description**

L'invention a pour objet un traitement antireflet résistant à la rayure pour matériau en saphir synthétique, mettant en oeuvre une implantation ionique et un recuit superficiel ultrarapide induit par micro-onde; ce procédé vise un traitement anti réflectif réduisant au moins de moitié la réflexion d'une onde dans le domaine visible en maintenant une dureté sur l'échelle de Mohs supérieure ou égale à 8. Le procédé de l'invention s'applique notamment sur la surface d'un verre de montre en saphir synthétique, sur des écrans d'affichage en saphir synthétique et tout autre objet ou l'on recherche sur la face externe en saphir synthétique à garantir une très grande résistance à la rayure et une bonne transmittance de la lumière dans le domaine visible (située entre 380 et 800 nm).

On entend par « saphir synthétique» un matériau transparent à la lumière visible. Le saphir synthétique est constitué d'oxyde de d'aluminium ($Al_2O_3$). Du point de vue physique, le saphir synthétique est un matériau cristallin très dur (dureté égale à 9 sur l'échelle de Mohs) appartenant à la famille des corindons, présentant un indice de réfraction très élevé égal à 1,76.

Les saphirs naturels sont constitués de cristaux d'oxyde d'aluminium ($Al_2O_3$) contenant des impuretés (oxydes) en traces qui leur donnent leur couleur (titane et fer pour le bleu, vanadium pour le violet, chrome pour le rose, fer pour le jaune et le vert). La couleur est due à l'apparition de niveaux énergétiques à l'intérieur de la bande interdite du corindon, du fait de la présence d'impuretés. Ces niveaux modifient les spectres d'émission et d'absorption du matériau et donc sa couleur.

Le saphir naturel peut être traité thermiquement ; les pierres, trop claires, trop sombres ou avec beaucoup d'inclusions, sont chauffées. Ce processus permet de rehausser couleur et clarté en dissolvant les éléments présents à l'état de traces dans la pierre.

Depuis le début du XIX$^e$ siècle, on sait fabriquer en laboratoire des saphirs synthétiques et des rubis synthétiques, dont la composition chimique et les propriétés physiques sont les mêmes que celles des pierres naturelles. On peut cependant détecter ces pierres synthétiques par leurs lignes de cristallisation généralement incurvées, du moins pour les productions les plus anciennes.

En raison de sa propriété de forte résistance aux rayures, le saphir synthétique est utilisé comme verre de montre ou lentille de caméra, notamment dans les smartphones. La fabrication de saphir synthétique est aujourd'hui au stade industriel.

Il est bien connu qu'une surface en saphir synthétique réfléchit environ 15,5% de la lumière incidente, réduisant la lecture d'une montre, d'un écran plat d'ordinateur ou de téléphone mobile.

Cette réflexion de la lumière sur une surface en saphir synthétique s'explique plus généralement par les relations de Fresnel qui donnent pour un rayon lumineux traversant un dioptre sous un angle d'incidence de 90°, les coefficients de réflexion (R) et de transmission (T) suivants :

$$R = ((n2-n1)/(n2+n1))^2 \; ; \; T = 4 \; n1*n2/(n2+n1)^2$$

Ou n1 et n2 sont les indices de réflexion des milieux séparés par le dioptre.
On constate que R+T = 1 (conservation de l'énergie)

Pour de l'air (n1= 1) et du saphir synthétique (n2 = 1,76) on obtient avec ces formules, R = 0,0758, T = 1-R = 0,9242 (seulement 7,6% est réfléchi alors que 92,4% est transmis).

Pour une lame de saphir synthétique constituée de deux faces, on a une perte qui est deux fois supérieure, 2 × 7,6% = 15,2%. Cette forte réflexion rend malaisée la lecture des composants d'une montre (aiguilles, calendrier, décors...) situés sous le verre de montre.

WO2014/126551 présente un traitement du saphir par implantation ionique de 10 à 100kV et recuit thermique entre 500 et 1800°C, les ions pouvant être d'azote, d'argon ou de titane. US 2011/200760 et US 2014/070119 décrivent un procédé similaire.

Les inventeurs ont développé un procédé antireflet consistant à implanter dans une surface en saphir synthétique des ions azote ou oxygène à une énergie comprise approximativement entre 20 et 40 keV (kilo électron Volt) et à des doses situées approximativement entre $5 \times 10^{16}$ ions/cm2 et $2 \times 10^{17}$ ions/cm2.

Ces traitements antireflets permettent d'augmenter significativement la transmittance d'une face traitée d'environs 6% (à titre indicatif la transmittance du saphir synthétique dont une seule face a été traitée passe de 85,5% à une valeur supérieure ou égale à 91,5% à 560 nm). Ce traitement présente toutefois un inconvénient : la dureté du saphir synthétique d'origine estimé à 9 sur l'échelle de Mohs, chute à 4-5 Mohs pour l'oxygène et à 7-8 pour l'azote. Pour des applications on l'on cherche à conserver autant que possible une inrayabilité proche voire comparable à celle du saphir synthétique, cela constitue un point rédhibitoire.

Cette chute de dureté est associée à une amorphisation du saphir synthétique dans la zone d'implantation parcourue par les ions. En cédant leur énergie les ions créent sur leur passage des défauts sous forme de lacunes qui ont pour effets de dégrader la structure cristalline du saphir synthétique et d'affaiblir les propriétés mécaniques superficielles du saphir synthétique. Au delà de la zone d'implantation qui n'excède pas approximativement 0,5 microns, on retrouve les caractéristiques en dureté du saphir synthétique. Les ions implantées situés en deçà de ces 0,5 microns permettent de créer un gradient d'indice à l'origine des propriétés anti-réflectives.

Les inventeurs ont procédé à des opérations de recuit classique (utilisant des fours à air ambiant) de saphir synthétique traité par implantation d'oxygène ou d'azote. Les conditions d'implantation étaient les suivantes : azote (30 keV (kilo électron Volt), dose implantée $1,5 \times 10^{17}$ ions/cm2) ; oxygène (30 keV (kilo électron Volt), dose implantée $1,5 \times 10^{17}$ ions/cm2). Les conditions de recuit avec four des saphirs synthétiques traités étaient les suivantes :(450, 800, 935 et 1450°C pendant 1 heure). Quelques soit le type d'ion et les conditions de recuit mises en oeuvre, le maintien des propriétés optiques (transmittance supérieure ou égale à 90%) s'accompagne d'une réduction de la dureté de Mohs (inférieure à 7) et l'augmentation de la dureté par recuit (dureté de Mohs tendant vers 8) s'accompagne d'une chute vertigineuse de la transmittance (inférieure à 88% pour 560 nm). La technique de recuit par four s'est révélée inopérante pour obtenir un traitement antireflet résistant à la rayure pour le saphir synthétique caractérisé par une dureté supérieure ou égale à 8 sur l'échelle de Mohs et une transmittance supérieure ou égale à 90% pour un saphir synthétique traité sur une seule face (correspondant à une réduction d'au moins 50% de la réflexion).

De tout ce qui précède, il résulte un besoin de traitement anti-réflectif d'un matériau en saphir synthétique dont les caractéristiques de résistance à la rayure sont sensiblement proche voire comparables à celle du saphir synthétique d'origine, de préférence selon des méthodes facilement industrialisables, de manière à pouvoir offrir de tels matériaux en saphir synthétique traité antireflet et résistant à la rayure en quantité significative et à des coûts raisonnables.

L'invention a pour but d'offrir un traitement antireflet résistant à la rayure par implantation ionique et recuit par microonde, peu onéreuse et permettant de traiter des surfaces répondant aux besoins de nombreuses applications. Parmi ces applications on citera : les écrans tactiles, les verres de montres, les lentilles d'un dispositif optique.

L'invention propose ainsi un procédé de traitement antireflet résistant à la rayure d'un matériau en saphir synthétique caractérisé par une dureté sur l'échelle de Mohs supérieure ou égale à 8 et par une réflexion réduite d'au moins de 50% pour une longueur d'onde de 560 nm, consistant en deux étapes :
**Une première étape** mettant en oeuvre un bombardement faisceau d'ions où :

- on choisit la dose d'ions implantés par unité de surface dans une plage comprise entre $10^{16}$ ions/cm$^2$ et $10^{18}$ ions/cm$^2$ de manière à obtenir une concentration atomique en ions telle que l'indice de réfraction n de la couche implantée est approximativement égale à $(n1*n2)^{1/2}$ ou n1 est l'indice de l'air et n2 l'indice du saphir synthétique;

- on choisit la tension d'accélération dans une plage comprise entre 5kV et 1000 kV de manière à obtenir une épaisseur implantée e égal à p*λ/4*n ou e est l'épaisseur implantée correspondant à une zone d'implantation ou la concentration atomique en ions implantés est supérieure ou égale à 1%, où p un nombre entier, λ la longueur d'onde incidente et n l'indice de la couche implantée.

**Une deuxième étape** ou l'on recuit superficiellement à des températures comprises entre 800 et 2000°C et sur deux très courtes durées comprises entre 0 et 1000 secondes en exposant les surfaces implantées à un échauffement superficiel ultrarapide produit par des micro-ondes.

Selon un mode de réalisation, les ions du faisceau d'ions sont sélectionnés parmi les ions des éléments de la liste des gaz dits « nobles », constituée de l'hélium (He), du néon (Ne), de l'argon (Ar), du krypton (Kr) et du Xénon (Xe) ;

Selon un autre mode de réalisation, les ions du faisceau d'ions sont sélectionnés parmi les ions des gaz de la liste constituée de l'azote (N$_2$) et l'oxygène (O$_2$).

Le choix des ions d'un gaz, des conditions de bombardement avec ces ions et des conditions de recuit selon l'invention permet d'obtenir avantageusement une réduction du coefficient de réflexion, une augmentation du coefficient de transmission et un maintien des propriétés de résistance à la rayure proche voire comparable à celle du saphir synthétique. Ces propriétés sont très importantes pour améliorer le confort de lecture d'une montre ou d'un écran en environnement extérieur, en réduisant fortement les reflets et en maintenant des caractéristiques de résistance à la rayure suffisantes au regard des agressions mécaniques que peuvent subir ces objets.

Les inventeurs ont pu constater que les plages choisies selon l'invention de tension d'accélération et de dose d'ions d'un gaz par unité de surface permettent de sélectionner des conditions expérimentales où la réduction des reflets (d'au moins 50%), est possible grâce à un bombardement ionique d'ions d'un gaz et que la couche implantée peut être résistante à la rayure en renforçant la dureté superficielle par un recuit superficiel ultrarapide induit par micro-ondes dans les plages indiquées par l'invention. Cette dureté doit après recuit être supérieure ou égale à 8 sur échelle de Mohs.

Lors d'une première étape, le choix de la dose d'ions d'un gaz par unité de surface dans la plage de dose selon l'invention peut résulter d'une étape préalable d'étalonnage où on bombarde avec un des ions d'un gaz, par exemple parmi He, Ne, Ar, Kr, Xe, N$_2$, O$_2$, un échantillon constitué du matériau en saphir synthétique envisagé. Le bombardement de ce matériau en saphir synthétique peut s'effectuer dans différentes zones du matériau avec une pluralité de doses d'ions d'un gaz, dans la plage selon l'invention. On mesure ensuite la transmittance à 560 nm des zones traitées de manière à choisir la dose optimale permettant d'atteindre une transmittance maximale (c'est dire une réflexion minimale).

Une deuxième étape consiste à régler la fréquence et la puissance des micro-ondes pour obtenir des montées en température les plus courtes possibles (par exemple 1 seconde) sur un saphir synthétique traité dans les conditions identifiées lors de la première étape. On expose ensuite plusieurs saphirs synthétiques traités dans les mêmes conditions que celles identifiées lors de la première étape à des températures de recuit échantillonnées de 200°C entre 800 et 2000°C, d'une valeur respective de 800, 1000, 1200, 1400, 1600, 1800°et 2000°C, selon trois durées de recuit de 1, 10 et 100 secondes pour chaque température de recuit, de manière à ne retenir que les conditions de recuit pour lesquelles la dureté de Mohs est supérieure ou égale à 8 et la réflexion est atténuée d'au moins 50% pour une longueur d'onde de 560 nm.

Il existe une autre technique de recuit superficiel ultrarapide qui présente, contrairement à celle utilisant des micro-ondes, l'inconvénient de ne pas être commercialement viable.

Sans vouloir être lié par une quelconque théorie scientifique, on peut penser que le phénomène de recuit ultrarapide avec des micro-ondes a pour effet de recuire les défauts cristallin (lacunes) à une vitesse supérieure à celle nécessaire pour diffuser les ions implantés, on augmente ainsi la dureté superficielle associée à la réduction des défauts (recristallisation) en dégradant le moins possibles les propriétés anti-réflectives associées aux ions implantés.

Selon différents modes de réalisation, qui peuvent être combinés :

- la dose d'ions d'un gaz par unité de surface est supérieure ou égale à $10^{16}$ ions/cm$^2$, par exemple supérieure ou égale à $10^{17}$ ions/cm$^2$;

- la tension d'accélération des ions d'un gaz est comprise entre 20 kV et 40 kV ;

- la tension d'accélération est choisie pour obtenir une épaisseur implantée égale à p* 100 nm où p est un nombre entier ;

- le matériau en saphir synthétique est mobile par rapport au faisceau d'ions d'un gaz à une vitesse, $V_D$, comprise entre 0,1 mm/s et 1000 mm/s ; selon un mode de réalisation, une même zone du matériau en saphir synthétique est déplacée sous le faisceau d'ions d'un gaz selon une pluralité, N, de passages à la vitesse $V_D$.

- le dispositif de recuit ultrarapide par micro-ondes du saphir synthétique traité comprend un générateur de signal RF, un amplificateur de puissance micro-onde, une tête d'échauffement micro-onde située au dessus du saphir synthétique traité à recuire, un pyromètre situé sous le saphir synthétique traité pour mesurer la température, un système d'asservissement piloté par ordinateur permettant de régler la fréquence du signal RF et l'amplificateur de puissance micro-onde pour obtenir des échauffements élevés et stable sur des durées de recuit relativement courtes variant de 1 à 1000 secondes. Pour plus de détails sur les principes techniques d'échauffement par micro-ondes on peut se reporter au brevet publié sous le n° EP0076769 A1.

La présente invention vise également une pièce en saphir synthétique comprenant au moins une surface avec un ion implanté et recuite par micro-onde selon le procédé de l'invention, selon l'un quelconque des modes de réalisation ci-dessus, où la réflexion d'une onde incidente de 560 nm est réduite d'au moins de moitié et la dureté de ladite surface est supérieure ou égale à 8 sur l'échelle de Mohs.

La présente invention vise également l'utilisation du procédé de traitement, selon l'une quelconque des modes de réalisation ci-dessus, pour traiter une pièce massive en saphir synthétique choisie parmi la liste constituée d'un écran tactile, d'un verre de montre, d'une lentille d'un dispositif optique.

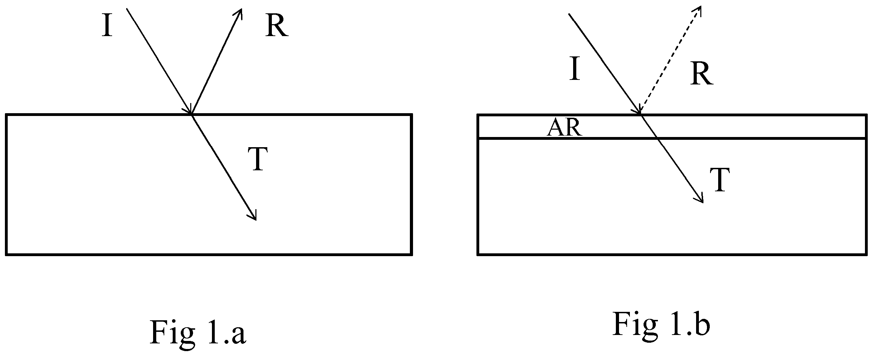

Les figures 1.a et 1.b décrivent la propagation d'une onde incidente sans et avec une couche antireflet ;

Selon des exemples de mise en oeuvre de la présente invention, des échantillons de matériau en saphir synthétique ont fait l'objet d'études, avec des ions azote mono et multichargés.

Ces ions d'un gaz mono et multichargés ont été émis par une source RCE.

Les inventeurs ont mené une première série d'essais avec un faisceau d'ions mono et multichargés d'azote d'une intensité de 1 mA comprenant des ions N$^+$ et N$^{2+}$ ; la tension d'accélération est de 20 kV ; l'énergie de N$^+$ est de 20 keV (kilo électron Volt) et celle de N$^{2+}$ de 40 keV (kilo électron Volt). La dose de traitement est égale à $1,5 \times 10^{17}$ ions/cm2. Les ions N$^+$ constituent approximativement 50% du faisceau, les ions N$^{2+}$ constituent approximativement 50% des ions restants.

Les échantillons en saphir se déplacent par rapport au faisceau avec une vitesse de déplacement à 80 mm/s et avec un pas d'avancement latéral à chaque retour de 4 mm (10% du diamètre faisceau qui mesure 40 mm). Pour atteindre la dose nécessaire le traitement se fait en plusieurs passes.

Les inventeurs ont constaté qu'à 560 nm la dose est optimale, la transmittance du saphir synthétique traité sur une seule face passe de 85% à 92%. La dureté de Mohs de la face traitée est comprise entre 7-8.

Pour des échantillons traités et recuits par micro-ondes à 1000°C pendant 100 s les inventeurs ont constaté que le saphir synthétique traité retrouve une dureté supérieure ou égale à 8 et que la transmittance demeure supérieure ou égale à 90% (réflexion de la face traitée réduite de 70%).

## Revendications

1. Procédé de traitement antireflet résistant à la rayure dans le domaine visible d'un matériau en saphir synthétique **caractérisé en ce qu'**il consiste en deux étapes successives: Une première étape mettant en oeuvre un bombardement par faisceau d'ions d'un gaz où :

   - on choisit la dose d'ions d'un gaz implantés par unité de surface dans une plage comprise entre $10^{16}$ ions/cm$^2$ et $10^{18}$ ions/cm$^2$ de manière à obtenir une concentration atomique en ions d'un gaz telle que l'indice de réfraction n de la couche implantée est approximativement égale à $(n1*n2)^{1/2}$ ou n1 est l'indice de l'air et n2 l'indice du saphir synthétique;
   - on choisit la tension d'accélération dans une plage comprise entre 5kV et 1000 kV de manière à obtenir une épaisseur implantée e égal à $p*\lambda/4*n$ ou e est l'épaisseur implantée correspondant à une zone d'implantation ou la concentration atomique en ions d'un gaz implanté est supérieure ou égale à 1%, où p un nombre entier, $\lambda$ la longueur d'onde incidente et n l'indice de la couche implantée;

   une deuxième étape où la surface du saphir synthétique implantée est recuite par un échauffement induit par des micro-ondes où:

   - on choisit des températures de recuit comprises entre 800 et 2000°C
   - on choisit des durées de recuit comprises entre 1 et 1000 secondes

2. Procédé selon la revendication 1 **caractérisé en ce que** les ions d'un gaz du faisceau d'ions sont sélectionnés parmi les ions des éléments de la liste constituée de l'hélium (He), du néon (Ne), de l'argon (Ar), du Krypton (Kr), du Xénon (Xe).

3. Procédé selon la revendication 1 **caractérisé en ce que** les ions d'un gaz du faisceau d'ions sont sélectionnés parmi les ions des gaz de la liste constituée de l'azote ($N_2$) et l'oxygène ($O_2$).

4. Procédé selon l'une quelconque des revendications précédentes **caractérisé en ce que** la tension d'accélération est choisie pour obtenir une épaisseur implantée égale à $p* 100$ nm où p est un nombre entier.

5. Procédé selon l'une quelconque des revendications précédentes **caractérisé en ce que** le matériau en saphir synthétique est mobile par rapport au faisceau d'ions d'un gaz mono et multichargés à une vitesse, $V_D$, comprise entre 0,1 mm/s et 1000 mm/s.

6. Procédé selon la revendication précédente **caractérisé en ce qu'**une même zone du matériau en saphir synthétique est déplacée sous le faisceau d'ions d'un gaz selon une pluralité, N, de passages à la vitesse $V_D$.

7. Pièce en saphir synthétique comprenant au moins une surface avec un ion implanté et recuite superficiellement selon l'une quelconque des revendications précédente **caractérisé en ce que** la réflexion d'une onde incidente de 560 nm soit réduite au moins de moitié et que ladite surface présente une dureté de Mohs supérieure ou égale à 8.

8. Utilisation du procédé de traitement selon l'une quelconque des revendications 1 à 7 pour traiter une pièce massive en saphir synthétique choisie parmi la liste constituée d'un écran tactile, d'un verre de montre, d'une lentille d'un dispositif optique.

## Patentansprüche

1. Verfahren zur kratzfesten Antireflexbehandlung im sichtbaren Bereich eines Materials aus synthetischem Saphir, **dadurch gekennzeichnet, dass** es aus zwei aufeinanderfolgenden Schritten besteht:
   einem ersten Schritt, in dem ein Gas mit einem Ionenstrahl beschossen wird, wobei:

- die Dosis der implantierten Gasionen pro Flächeneinheit in einem Bereich von $10^{16}$ Ionen/cm$^2$ bis $10^{18}$ Ionen/cm$^2$ gewählt wird, um eine solche atomare Konzentration von Gasionen zu erhalten, dass der Brechungsindex n der implantierten Schicht ungefähr gleich $(n1*n2)^{1/2}$ ist, wobei n1 der Index von Luft und n2 der Index des synthetischen Saphirs ist;

- die Beschleunigungsspannung in einem Bereich zwischen 5 kV und 1000 kV gewählt wird, um eine implantierte Dicke e gleich $p*\lambda/4*n$ zu erhalten, wobei e die implantierte Dicke ist, die einem Implantationsbereich entspricht, in dem die atomare Konzentration von Ionen eines implantierten Gases größer oder gleich 1% ist, oder p eine ganze Zahl ist, $\lambda$ die Länge der einfallenden Welle und n der Index der implantierten Schicht ist;

- einen zweiten Schritt, in dem die Oberfläche des implantierten synthetischen Saphirs durch mikrowelleninduzierte Erwärmung geglüht wird, wobei:

- Glühtemperaturen zwischen 800 und 2000°C gewählt werden.

- Glühzeiten zwischen 1 und 1000 Sekunden gewählt werden.

**2.** Verfahren nach Anspruch 1, **dadurch gekennzeichnet, dass** die Ionen eines Gases des Ionenstrahls aus den Ionen der Elemente der Liste, umfassend Helium (He), Neon (Ne), Argon (Ar), Krypton (Kr), Xenon (Xe) gewählt werden.

**3.** Verfahren nach Anspruch 1, **dadurch gekennzeichnet, dass** die Ionen eines Gases des Ionenstrahls aus den Ionen der Gase der Liste, umfassend Stickstoff ($N_2$) und Sauerstoff ($O_2$) gewählt werden.

**4.** Verfahren nach einer der vorhergehenden Ansprüche, **dadurch gekennzeichnet, dass** die Beschleunigungsspannung so gewählt wird, dass eine implantierte Dicke von $p*100$ nm erreicht wird, wobei p eine ganze Zahl ist.

**5.** Verfahren nach einem der vorhergehenden Ansprüche, **dadurch gekennzeichnet, dass** das synthetische Saphirmaterial in Bezug auf den Ionenstrahl eines ein- und mehrfach geladenen Gases mit einer Geschwindigkeit $V_D$, zwischen 0,1 mm/s und 1000 mm/s beweglich ist.

**6.** Verfahren nach dem vorhergehenden Anspruch, **dadurch gekennzeichnet, dass** derselbe Bereich des synthetischen Saphirmaterials unter dem Ionenstrahl eines Gases in einer Vielzahl, N, von Durchgängen mit der Geschwindigkeit $V_D$ bewegt wird.

**7.** Synthetisches Saphirteil, umfassend wenigstens eine Oberfläche mit einem implantierten und oberflächengeglühten Ion nach einem der vorstehenden Ansprüche, **dadurch gekennzeichnet, dass** die Reflexion einer einfallenden Welle von 560 nm wenigstens um die Hälfte reduziert ist und dass die Oberfläche eine Mohs-Härte von 8 oder mehr aufweist.

**8.** Anwendung des Bearbeitungsverfahrens nach einem der Ansprüche 1 bis 7 zur Bearbeitung eines massiven Teils aus synthetischem Saphir, gewählt aus der Liste, umfassend einen Touchscreen, ein Uhrglas, eine Linse eines optischen Geräts.

**Claims**

**1.** Method of antireflection scratch-resistant treatment in the visible range of a synthetic sapphire material, **characterized in that** it consists of two successive steps:

a first step that carries out a bombardment by a beam of gas ions where:

- the dose of gas ions implanted per unit of surface area is chosen within a range between $10^{16}$ ions/cm$^2$ and $10^{18}$ ions/cm$^2$ so as to obtain an atomic concentration of gas ions such that the refractive index n of the implanted layer is approximately equal to $(n1*n2)^{1/2}$ where n1 is the index of the air and n2 is the index of the synthetic sapphire;

- the acceleration voltage is chosen within a range between 5 kV and 1000 kV so as to obtain an implanted thickness e equal to $p*\lambda/4*n$ where e is the implanted thickness corresponding to an implantation zone where the atomic concentration of implanted gas ions is greater than or equal to 1%, where p is an integer, $\lambda$ is the incident wavelength and n is the index of the implanted layer,

a second step where the implanted surface of the synthetic sapphire is annealed by microwave-induced heating where:

- annealing temperatures are chosen within a range between 800°C and 2000°C;
- annealing times are chosen within between 1 and 1000 seconds.

2. Method according to Claim 1, **characterized in that** the gas ions of the beam of ions are selected from the ions of the elements from the list consisting of helium (He), neon (Ne), argon (Ar), krypton (Kr), xenon (Xe).

3. Method according to Claim 1, **characterized in that** the gas ions of the beam of ions are selected from the ions of the gases from the list consisting of nitrogen ($N_2$) and oxygen ($O_2$).

4. Method according to any one of the preceding claims, **characterized in that** the acceleration voltage is chosen so as to obtain an implanted thickness equal to p*100 nm where p is an integer.

5. Method according to any one of the preceding claims, **characterized in that** the synthetic sapphire material is movable relative to the beam of singly-charged and multicharged gas ions at a speed, $V_D$, of between 0.1 mm/s and 1000 mm/s.

6. Method according to the preceding claim, **characterized in that** a same zone of the synthetic sapphire material is moved under the beam of gas ions according to a plurality, N, of passes at the speed $V_D$.

7. Synthetic sapphire part comprising at least one surface with an implanted and surface-annealed ion according to any one of the preceding claims, **characterized in that** the reflection of an incident wave of 560 nm is reduced at least by half and that said surface has a Mohs hardness of greater than or equal to 8.

8. Use of the treatment method according to any one of Claims 1 to 7, for treating a solid synthetic sapphire part chosen from the list consisting of a touch screen, a watch glass, a lens of an optical device.

Fig 1.b

Fig 1.a

## RÉFÉRENCES CITÉES DANS LA DESCRIPTION

### Documents brevets cités dans la description

- WO 2014126551 A
- US 2011200760 A
- US 2014070119 A
- EP 0076769 A1